# EUROPEAN PATENT APPLICATION

(11) **EP 1 531 366 A2**
(43) Date of publication of application: **18.05.2005**
(21) Application number: 04105208.5
(22) Date of filing: 21.10.2004
(51) Int. Cl.: G03F 9/00

(54) **Back to front alignment with latent imaging**

(30) Priority: 14.11.2003 EP 03104201
(71) Applicant: International Business Machines Corporation, Armonk, N.Y. 10504 (US)
(72) Inventor: Mueller, Thilo, 55234, Bechtolsheim (DE); Mallmann, Hans-Jörg, 56154, Boppard (DE); Benczek, Rainer, 55543, Bad Kreuznach (DE)
(74) Representative: Teufel, Fritz

(57) **Abstract**

The invention relates to a method for lateral alignment of a substrate for photolithography, wherein the substrate's back side has a reference mark and the substrate front side is coated with a photoresist, the method for lateral alignment comprising the steps of:
- retrieving the reference mark on the substrate's back side,
- applying an alignment mark on the front side of the substrate by means of a first exposure of the photoresist with electromagnetic radiation to provide an undeveloped alignment mark, the undeveloped alignment mark being laterally positioned on the photoresist with respect to the reference mark on the substrate's back side,
- aligning the substrate by making use of the undeveloped alignment mark,
- applying a further manufacturing process on the front side of the aligned substrate.

## Description

### Field of the invention

The present invention relates to the field of lateral alignment of a substrate during a lithography process.

### Background and prior art

The manufacturing process for electronic or micro-mechanical components incorporates a multitude of surface treatment procedures such as chemical etching, coating, laser beam ablation and the like. In order to produce mechanical or electrical surface structures on a micrometer scale or even on a sub-micrometer scale, chemical etching in combination with a mask generated by a photolithographic technique is commonly used. Typically in photolithography, a photo sensitive material coated on a surface of a substrate is exposed with a spatial light pattern in a first step. In a successive step the exposed photoresist is developed in order to create a structured surface of the substrate which is then subject to further process steps of e.g. etching, coating, evaporating or ion implantation.

In the majority of cases, the photolithographic procedure itself only provides a structured mask which is needed for a successive surface treatment procedure, as e.g. etching. Typically, after the appliance of such surface treatment process steps, the photo sensitive layer is completely removed. Typically a photo sensitive layer, a photo resist, only acts as an intermediate medium to provide a spatially structured mask for surface treatment processes.

The entire production process of electronic semiconductor components or micro mechanical components typically makes use of a plurality of coating and etching processes in combination with various lithographic processes. Since the different steps of surface treatment or lithography are separately processed by different devices, a proper and accurate alignment, in particular lateral alignment, is essential and crucial for the quality of the final product. In order to provide and to guarantee a proper layer overlay, alignment marks are applied on the substrate. These alignment marks allow an exact alignment of the substrate for each of the successive manufacturing processes of the electronic semiconductor component. With the help of a visual detection of the position of the alignment mark, the substrate can be exactly laterally aligned prior to execution of successive surface treatment steps.

Alignment marks applied on a layer of photoresist are sometimes insufficient, because a photoresist typically does not reside on the substrate during the entire production process. Hence the alignment mark only survives a limited number of process steps.

In order to overcome the insufficiency of temporary alignment marks, permanent reference marks have been introduced on the back side of a substrate. Since the alignment of a substrate with a back side reference mark is rather costly and involves a whole imaging apparatus of the substrate's back side, it is desirable to project the permanent reference mark of the back side of the substrate to the front side of the substrate, which is subject to surface treatment.

US Pat. No. 5,361,132 discloses a back to front alignment of elements on a substrate. This back to front alignment technique makes use of a pair of grating elements having a reference center line there between provided on the front surface thereof, the reference center line being at a known position relative to the features present on such surface, which features are to be replicated in an aligned fashion on the opposite or back surface of the substrate. A beam of electromagnetic energy is applied to the grating elements so as to generate an interference fringe pattern having a reference center bright space on the opposite surface of the substrate, the center bright space corresponding to, and being aligned with the reference center line of the grating elements on the front side. The position of the center reference bright space of the interference fringe pattern is determined and a corresponding reference marker or a mask element having the locations of the desired features suitably placed thereon is aligned therewith using a suitable alignment system.

Since this method is based on the generation of interference fringe patterns on the opposite surface of the substrate, the substrate has to be transparent. Therefore, this method cannot be applied to non-transparent substrates or layers.

US Pat. No. 5,338,630 discloses a photolithography controlled method. This control method makes explicit use of a so-called latent image which is exposed but remains undeveloped in the photosensitive layer. The method includes the steps of loading a wafer having a layer of photoresist into a photolithography system, exposing the photoresist in accordance with an initial set of control parameters including exposure time, (providing exposure energies), position of the wafer within the photolithography system and focus. Prior to developing the photoresist, optical characteristics of the exposed photoresist are observed by a phase contrast microscope which detects latent images. Then, according to the observations of the latent image, the initial set of control parameters are adjusted to generate a second set of control parameters.

The present invention aims to provide an improved method, an apparatus, a substrate as well as a computer program product for the backside alignment of substrates for a photolithography process.

### Summary of the invention

The invention provides for a method for lateral alignment of a substrate in a photolithography process. The substrate's back side has a permanent reference mark and the substrate's front side is coated with a photoresist. It is an object of the invention to provide a back to front alignment, which means that a temporary alignment mark is applied on the front side of the substrate depending on the position of the permanent reference mark on the substrate's back side.

In a first step the position of the permanent reference mark has to be retrieved on the substrate's back side. Typically, the permanent reference mark on the substrates back side is directly visible and its position can easily be detected by some kind of imaging and image processing system. After the exact position of this permanent reference mark has been determined, a temporary alignment mark is applied on the front side of the substrate by means of a first exposure of the photoresist on the front side of the substrate. The position of this temporary alignment mark is calculated on the basis of the determined position of the permanent reference mark on the back side of the surface. The temporary alignment mark can therefore be interpreted as a temporary projection of the permanent reference mark located on the back side of the substrate.

The temporary alignment mark is typically generated by a relatively short exposure of the photoresist which leads to a structural change of the photoresist that can be detected visually or by means of optical phase contrast. It is essential that the position of the temporary alignment mark can be detected by optical means without developing the exposed layer of photoresist. Since the lateral position of the temporary alignment mark on the front side of the substrate can be directly detected, the alignment of the substrate can be performed with high accuracy prior to developing the photoresist. Once a proper alignment of the substrate has been performed, successive surface treatment processes, preferably in form of an additional exposure of the photoresist can take place.

According to a further preferred embodiment of the invention, the lateral position of the substrate is determined on the basis of the lateral position of the temporary, hence undeveloped alignment mark. The position of the undeveloped alignment mark or the position of the latent image can be determined by means of an optical imaging system in combination with an image processing system. Depending on the type of photoresist, a structural change in the photoresist, which is due to the first exposure can be detected visually or e.g. by making use of phase contrast imaging methods. In both cases, the lateral position of the latent image can be determined without developing of the first exposure.

Making use of a latent image for the purpose of lateral alignment of a substrate is extremely advantageous in the sense, that a development step in which the temporary alignment mark is developed, can be skipped. In this way the number of steps for a conventional alignment procedure making use of a temporary alignment mark can be reduced, because the intermediate development step for visualizing the alignment mark can be left out. It is obvious, that the utilization of latent imaging provides a time and cost reduction for the entire manufacturing process. This kind of economization is indeed appreciable, because alignment processes in combination with photolithography have to be performed several times during a manufacturing process.

According to a further preferred embodiment of the invention, the lateral position of the permanent reference mark on the substrate' back side can be determined visually. The permanent reference mark features some kind of image whose position has to be determined by some kind of imaging system in combination with an image processing system. Since the method of the present invention generates a temporary alignment mark on the front side of the substrate, such an imaging system for the detection of the position of the reference mark is only required once as long as the temporary alignment mark resides on the front side of the substrate. Only the distinct apparatus that generates the latent image on the front side of the substrate requires such optical means for the detection of the position of the permanent reference mark on the substrate's back side.

According to a further preferred embodiment of the invention, the permanent reference mark can be applied as a notch somewhere in the circumference of the substrate. In this way the determination of the position of the permanent reference mark is simplified, because an imaging system of the substrates back side is not necessarily needed. Therefore, the position of the permanent reference mark can be determined by an optical system which is located on the same side of the substrate as the optical system for the exposure of a temporary alignment mark. Preferably the optical systems for detecting the position of the permanent reference mark and for exposing the temporary alignment mark are incorporated in one optical system. This decreased the operative complexity of the entire alignment and manufacturing system.

According to a further preferred embodiment of the invention, transparent as well as non-transparent substrates can be used. Since the position of the permanent reference mark on the back side of the substrate is determined by an optical imaging system which is located below the substrate, i.e. near the back side of the substrate, the substrate does not have to be transparent in order to apply the latent image on the photoresist on the front side of the substrate. This means, that the position of the permanent reference mark is retrieved from the back side and the latent image is exposed on the photoresist from the front side of the substrate. In contrast to the back to front alignment of US Pat. No. 5,361,132, the medium of the substrate can be non-transparent for the electromagnetic radiation used for the exposure.

According to a further preferred embodiment of the invention, the photoresist on the front side of the substrate can be subject to a second exposure with electromagnetic radiation prior to developing the temporary, hence undeveloped alignment mark. Especially this feature is of extreme advantage, since the conventional intermediate step of developing an exposed alignment mark can be left out. Due to the fact, that the exposed, but undeveloped temporary alignment mark is either directly visible or can effectively be detected by means of optical phase contrast techniques, a proper and accurate lateral alignment of the substrate can be provided before an additional exposure of the photoresist takes place.

Conventional techniques comprise a developing of the photoresist in order to visualize the position of the temporary alignment mark. In order to apply the required spatial pattern on the substrate, it has to be coated with an additional layer of photoresist in a next step. Then, a new alignment on the basis of a developed alignment mark has to take place, before the second exposure, i.e. the applying of the required spatial pattern on the photoresist, can take place.

According to the aforementioned embodiment of the invention, the temporary alignment mark as well as the desired spatial pattern can be applied on the same photoresist without performing an intermediate development step. Since the invention provides a skipping of such an intermediate development process, the number of process steps required for the entire manufacturing of the product reduces. Such a reduction of process steps saves time and costs.

According to a further preferred embodiment of the invention, the temporary alignment mark of the first exposure as well as a spatial pattern of the second exposure are developed simultaneously in a successive development step. After such a development process step, both the developed alignment mark as well as the desired spatial pattern are directly visible on the front side of the substrate. Once, the substrate has been prepared in this way it can be subject to successive process steps of e.g. chemical etching, ion implantation or coating. For these successive process steps, the developed alignment mark serves as a means for aligning the substrate and the developed spatial pattern of the second exposure serves as a mask.

According to a further preferred embodiment of the invention, the temporary alignment mark can be applied on the front side of the substrate in a predefined way, i.e. its relative lateral position with respect to the lateral position of the permanent reference mark on the back side of the substrate can be defined according to a user's specification. For example the temporary alignment mark in form of a latent image can be realized as a direct projection of the back side's reference mark.

Furthermore, the latent image can also be applied at a different lateral position on the front side of the substrate. In the latter case, the relative lateral position of the temporary alignment mark with respect to the permanent reference mark has to be defined for a distinct type of substrate. In this way the method can be universally applied to various types of substrates having a different surface structure and therefore require different positions of a temporary alignment mark. When for example a first substrate requires a surface treatment in its central area and when a second substrate requires surface treatment near the edges of its surface, the alignment mark for the first substrate can be applied near the edge of the substrate while the temporary alignment mark of the second substrate can be applied in the central area of the substrate.

In this way the method of the present invention allows an application of temporary alignment marks on the front side of a substrate depending on the required surface structure of the substrate. The temporary alignment marks are preferably applied to such portions of the surface of the substrate, that are irrelevant for the successive manufacturing processes.

Therefore, various substrates supported by a supplier having the same permanent reference mark on the substrate's back side, can be universally used for the manufacturing of different electronic components with a different surface structure and hence requiring different alignment marks during the manufacturing process.

According to a further preferred embodiment of the invention, the spatial structure of the temporary alignment mark can be designed in an arbitrary way. For example the temporary alignment mark exactly represents the spatial structure of a permanent reference mark on the back side of the substrate. Alternatively it can feature an arbitrary geometric structure such as a cross, a circle, a square or some other geometrical object serving as a reticle.

According to a further preferred embodiment of the invention, a plurality of temporary alignment marks can be applied on the front side of the substrate. Each of the plurality of alignment marks having a different lateral position. The plurality of temporary alignment marks can be applied on the photoresist by means of a single or by means of a plurality of exposures with electromagnetic radiation. Since the exposed alignment marks are not developed prior to a second exposure applying a spatial pattern on the photoresist, the different alignment marks can be applied in a sequential way.

Since the single alignment marks on the front side of the surface comprise a relative lateral distance, not only the positioning but also the orientation of the substrate can be performed in an easy and efficient way. When in contrast the alignment of a substrate is performed by means of a single alignment mark, an accurate orientation of the substrate requires that the geometrical structure of the temporary alignment mark has to be taken into account. Whereas when two temporary alignment marks are present on the front side of the substrate, the accurate position as well as an accurate orientation can be performed only on the basis of the position of the two alignment marks.

In this case the alignment marks do not require a distinct geometrical structure. For example in a very simple case the two alignment marks can be implemented as dots or circles that are easy to produce and easy to detect.

The invention therefore provides an efficient approach for back to front alignment of a substrate for a lithography process. Since a temporary alignment mark is applied on the front side of the substrate by making use of a permanent reference mark on the substrate's back side, the permanent reference mark has only to be retrieved by a limited number of process steps during the manufacturing of an electronic or micro-mechanic product. This is of extreme advantage because a stepper performing the second exposure and thereby applying a high resolution spatial pattern on the photoresist does usually not comprise means for retrieving reference marks that are located on the back side of a substrate.

### Brief description of the drawings

In the following, preferred embodiments of the invention will be described in greater detail by making reference to the drawings in which:
- Figure 1: illustrates a cross section of a substrate with reference and alignment marks,
- Figure 2: is illustrative of a flow chart of the alignment method of the invention,
- Figure 3: shows a developed alignment mark,

- Figure 4: illustrates a top view of a substrate with a permanent reference notch and two temporary alignment marks.

### Detailed description

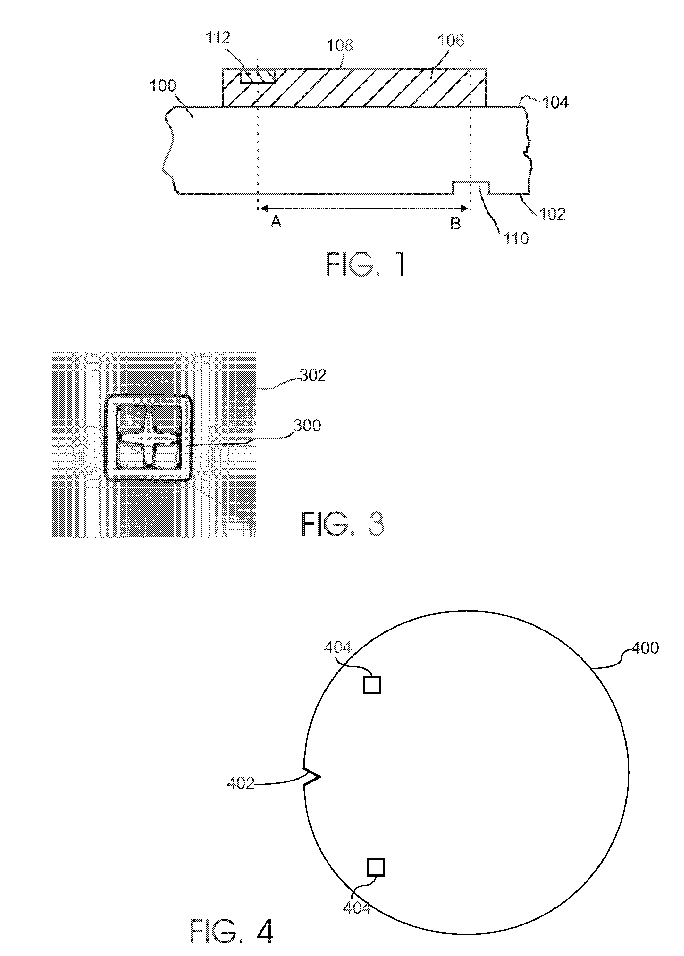

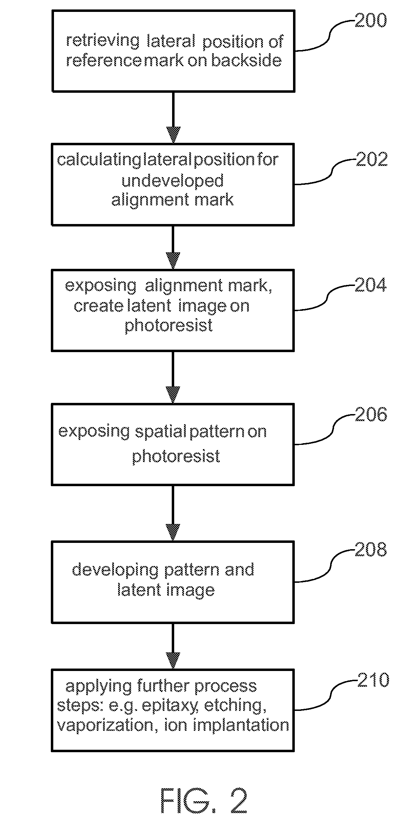

Figure 1 shows a side view of a substrate 100 having a back surface 102 and front surface 104. The substrate 100 is coated with a photoresist 106 on the front surface 104. The photoresist 106 has a surface 108 as well as a temporary alignment mark 112. The back surface 102 of the substrate 100 has a permanent reference mark 110.

The permanent reference mark 110 located at the back side of the substrate is illustrated as a notch. The lateral position B of the permanent reference mark 110 can be retrieved by optical means, e.g. a backside microscope. Depending on the lateral position of the permanent reference mark 110 on the backside of the substrate 102, a lateral position A of the temporary alignment mark 112 to be applied on the photoresist 106 is determined. The lateral distance between the positions of the temporary alignment mark A and the permanent reference mark B can be adapted according to the specifications of the manufacturing process.

The temporary alignment mark 112 is applied on the photoresist 106 by a short exposure of the surface of the photoresist 108 by means of electromagnetic radiation. Since the lateral distance between the temporary alignment mark 112 and the permanent reference mark 110 is somehow specified, the temporary alignment mark in the form of the latent image 112 is utilized for an accurate alignment of the substrate 100 for successive surface treatment processes in the framework of the manufacturing of an electronic or micro-mechanical component.

The first exposure of the photoresist resulting in the generation of the latent image 112 induces a local structural change of the photoresist in the area of the latent image 112.

This structural change is either directly visible or can be visualized by optical means, e.g. an optical phase contrast technique. In this way the position A of the latent image 112 and hence the position of the substrate 100 can be determined in an accurate way for the purpose of successive treatment of the surface 108 of the photoresist and/or further treatment of the surface 104 of the substrate 100.

When the substrate 100 has been properly aligned, a second exposure of the surface 108 of the photoresist layer 106 can take place. By means of this second exposure, a lateral spatial structure is applied in the photoresist 106. The structural changes of the photoresist 106 that are due to the second exposure penetrate the photoresist 106 up to the surface 104 of the substrate 100. During the proceeding developing process, the latent image 112 as well as the applied spatial structure of the second exposure are developed by removing exposed or unexposed portions of the photoresist 106.

The developed photoresist then serves as a mask for further surface treatment of the surface 104 of the substrate 100. During further process steps, the entire photo resist 106 including the latent image 112 may be completely removed. In such a case the permanent reference mark 110 on the backside of the substrate 100 can again be used to specify the position and orientation of the substrate 100. In combination with an additional coating of the surface 104 of the substrate 100 with a photoresist layer, the described procedure of producing a latent image 112 can be applied repeatedly.

Figure 2 is illustrative of a flow chart of the alignment method of the present invention. In a first step 200 the lateral position of the permanent reference mark located on the back side of the substrate is retrieved. Depending on this retrieved position, in a next step 202 a lateral position for the temporary alignment mark is calculated. This calculation can be based on process- or user specifications, requiring a defined lateral distance between the permanent reference mark on the back side and the temporary alignment mark on the front side of the substrate. In the proceeding step 204, the photoresist is subject to a first exposure in which the temporary alignment mark is applied in the photoresist. In this way the latent image is created which is detectable by optical means without developing of the photoresist. Based on the applied temporary alignment mark in form of the latent image, the entire substrate can be aligned before successive process steps are applied.

In the proceeding step 206, a successive process step in form of a second exposure is applied on the photoresist. Typically this type of exposure provides a high resolution spatial pattern on the photoresist which serves as a mask for further surface treatment processes after developing. This second exposure is typically performed by a stepper or scanner that has no means to retrieve the permanent reference mark on the substrate's back side. After the second exposure of the photoresist has been performed in step 206, the exposed photoresist is developed in the next step 208. In this step the latent image as well as the spatial pattern due to the second exposure are developed simultaneously. Developing typically comprises removing exposed or unexposed portions of the photoresist. In this way a mask is generated which is used for further surface treatment processes like epitaxy, etching, vaporisation or ion implantation. The plurality of different surface treatment processes requiring a mask generated by photolithography are summarized in step 210.

Figure 3 shows an image of a temporary alignment mark. The temporary alignment mark 300 has a geometrical structure incorporating a square and a cross. In this case a temporary alignment mark or the latent image 300 is directly visible due to a different brightness than the background 302. The background 302 can either be developed photoresist or the front surface of the substrate.

Since the latent image has a non-circular symmetry, the substrate can be positioned as well as orientated by means of a single temporary reference mark 300.

Figure 4 shows a drawing of a top view of a substrate 400 having a permanent reference notch 402 and two temporary alignment marks 404. The substrate 400 featuring a circular shape has a notch 402 located at its border. The location of the notch/flat as permanent reference mark can be detected from either front- or back side of the substrate. In such a case, a back side microscope for the determination of the position of the permanent reference mark is not needed.

The position of the permanent reference mark 402 can therefore be determined by optical means from the front side of the substrate 400. Furthermore the figure illustrates two latent images 404 that are located at different positions on the substrate 400. In this particular case the latent images 404 have a rectangular shape. An accurate and proper alignment of the substrate 400 can be performed only with respect to the positions of the two temporary alignment marks 404. An analysis of the geometrical structure of a latent image 404 is not required. In such a case the geometrical structure of a latent image 404 can be very simple and may even have a circular symmetry.

### LIST OF REFERENCE NUMERALS

- 100: substrate
- 102: back side of substrate
- 104: front surface of substrate
- 106: photoresist layer
- 108: surface of photoresist
- 110: permanent reference mark
- 112: temporary alignment mark
- 300: temporary alignment mark
- 302: surface of substrate
- 400: substrate
- 402: permanent reference notch
- 404: temporary alignment mark

## Claims

1. A method for lateral alignment of a substrate(100; 400) for photolithography, wherein the substrate's back side (102) has a reference mark (110; 402) and the substrate's front surface (104) is coated with a photoresist (106), the method for lateral alignment comprising the steps of:
- retrieving the position of the reference mark (110) on the substrate's back side (102),
- applying an alignment mark (112; 404) on the front surface (104) of the substrate by means of a first exposure of the photoresist (106) with electromagnetic radiation to provide an undeveloped alignment mark (112; 404), the undeveloped alignment mark being laterally positioned on the photoresist (106) with respect to the position reference mark on the substrate's back side,
- aligning the substrate (100; 400) by making use of the undeveloped alignment mark (112),
- applying a further manufacturing process on the front side of the aligned substrate (100; 400).

2. The method according to claim 1, wherein the lateral position of the substrate (100; 400) is determined on the basis of the lateral position of the undeveloped alignment mark (112; 404), which is either determined by visual means or by means for measuring an optical phase contrast.

3. The method according to claim 1 or 2, wherein the lateral position of the reference mark (110; 402) on the substrate's back side (102) is determined visually.

4. The method according to any one of the claims 1 to 3, wherein the substrate (100; 400) and/or the photoresist (106) on the front side of the substrate are transparent or non-transparent for the applied electromagnetic radiation.

5. The method according to any one of the claims 1 to 4, wherein the further manufacturing process of the substrate comprises:
- applying a spatial pattern on the photoresist (106) by means of a second exposure of the photoresist with electromagnetic radiation prior to developing the undeveloped alignment mark (112; 404),
- developing of the spatial pattern and developing of the undeveloped alignment mark (112; 404) of the second and first exposure with electromagnetic radiation.

6. The method according to any one of the claims 1 to 5, wherein the alignment mark (112; 404) is laterally positioned with respect to the position of the reference mark (110; 402) on the substrate's back side, the alignment mark having a predefined lateral distance from the reference mark.

7. The method according to any one of the claims 1 to 6, wherein a plurality of undeveloped alignment marks (404) is laterally positioned and applied with respect to the reference mark (402) by means of subsequent or simultaneous exposures of the photoresist (106) with electromagnetic radiation, each of the plurality of undeveloped alignment marks (404) having a predefined lateral distance from the reference mark (402).

8. An apparatus for photolithography with means for lateral alignment of a substrate (100; 400), the back side of the substrate having a reference mark (102) and the substrate's front surface (104) is coated with a photoresist (106), the apparatus comprising:
- means for retrieving the position of the reference mark (110) on the substrate's back side (102),
- means for applying an alignment mark on the front surface (104) of the substrate (100; 400) being adaptive for performing a first exposure of the photoresist (106) with electromagnetic radiation, to provide an undeveloped alignment mark (112; 404), the undeveloped alignment mark being laterally positioned on the photoresist (106) with respect to the position of the reference mark (110) on the substrate's back side,
- means for aligning the substrate (100; 400) by making use of the undeveloped alignment mark (112; 404),
- means for applying a further manufacturing process on the front side of the aligned substrate (100; 400).

9. The apparatus according to claim 8, further comprising means for determining the lateral position of the substrate (100) on the basis of the lateral position of the undeveloped alignment mark (112; 404), which is either determined by visual means or by means for measuring an optical phase contrast.

10. The apparatus according to claim 8 or 9, further comprising:
- means for applying a spatial pattern on the photoresist (106) by means of a second exposure of the photoresist with electromagnetic radiation prior to developing the undeveloped alignment mark (112; 404),
- means for developing of the spatial pattern and means for developing of the undeveloped alignment mark (112; 404) of the second and first exposure with electromagnetic radiation.

11. The apparatus according to any one of the claims 8 to 10, comprising means for applying a plurality of alignment marks (404), the plurality of alignment marks being laterally positioned with respect to the position of the reference mark (402) by means of subsequent or simultaneous exposures of the photoresist (106) with electromagnetic radiation, each of the plurality of alignment marks (404) having a predefined lateral distance from the reference mark.

12. A substrate for photolithography, wherein the substrate's back side (102) has a reference mark (110) and the substrate's front surface (104) is coated with a photoresist (106), the substrate comprising an undeveloped alignment mark (112; 404) generated by a first exposure of the photoresist with electromagnetic radiation, the position of the undeveloped alignment mark is detectable by optical means.

13. The substrate according to claim 12, wherein the optical means for determining the position of the undeveloped alignment mark (112; 404) comprise visual detection or means for measuring an optical phase contrast.

14. The substrate according to claim 12 or 13, wherein a spatial pattern can be applied on the photoresist (106) by means of a second exposure of the photoresist with electromagnetic radiation prior to developing the alignment mark (112; 404).

15. A computer program product for a lateral alignment of a substrate (100; 400) for photolithography, the back side (102) of the substrate having a reference mark (110) and the substrate's front surface (104) being coated with a photoresist (106), the computer program product comprising:
- program means for retrieving the position of the reference mark (110) on the substrate's back side (102),
- program means for applying an alignment mark (112; 404) on the front side of the substrate being adapted to perform a first exposure of the photoresist with electromagnetic radiation, the alignment mark (112; 404) being laterally positioned on the photoresist with respect to the position of the reference mark (110) on the substrate's back side (102),
- program means for aligning the substrate (100; 400) by making use of the undeveloped alignment mark (112; 404),
- program means for applying a further manufacturing process on the front side of the aligned substrate (100; 400).

16. The computer program product according to claim 15, further comprising program means for determining the lateral position of the substrate (100; 400) on the basis of the lateral position of the undeveloped alignment mark (112; 404), which is either determined by visual means or by means for measuring an optical phase contrast.

17. The computer program product according to claim 15 or 16, further comprising program means for the determining the lateral position of the reference mark (110) on the substrate's back side (102) on the basis of visual means.

18. The computer program product according to any one of the claims 15 to 17, for applying a further manufacturing process on the front side of the aligned substrate, further comprising program means for:
- applying a spatial pattern on the photoresist (106) by means of a second exposure of the photoresist with electromagnetic radiation prior to developing the undeveloped alignment mark (112; 404),
- developing of the spatial pattern and developing of the undeveloped alignment mark of the second and first exposure with electromagnetic radiation.

19. The computer program product according to any one of the claims 15 to 18, comprising program means for laterally positioning the undeveloped alignment mark (112; 404) with respect to the position of the reference mark (110) on the substrate's back side (102), the alignment mark having a predefined lateral distance from the reference mark.

20. The computer program product according to any one of the claims 15 to 19, further comprising program means for applying and positioning a plurality of undeveloped alignment marks (404) on the photoresist (106) with respect to the reference mark by means of subsequent or simultaneous exposures of the photoresist (106) with electromagnetic radiation, each of the plurality of undeveloped alignment marks (404) having a predefined lateral distance from the reference mark (110; 402).
